**Europäisches Patentamt**

**European Patent Office**

**Office européen des brevets**

(19)

(11) Veröffentlichungsnummer: **0 122 300**
**B1**

(12) # EUROPÄISCHE PATENTSCHRIFT

(45) Veröffentlichungstag der Patentschrift:
28.01.87

(21) Anmeldenummer: **83103435.0**

(22) Anmeldetag: **08.04.83**

(51) Int. Cl.⁴: **H 03 H 11/24,** H 03 J 5/02

(54) **Integrierte Schaltung zur Erzeugung einer mittels eines Digitalsignals einstellbaren Klemmenspannung.**

(43) Veröffentlichungstag der Anmeldung:
**24.10.84 Patentblatt 84/43**

(45) Bekanntmachung des Hinweises auf die Patenterteilung:
**28.01.87 Patentblatt 87/5**

(84) Benannte Vertragsstaaten:
**DE FR GB IT NL**

(56) Entgegenhaltungen:
**WIRELESS WORLD, Band 85, Nr. 1528, Dezember 1979, Seite 60, Hayward Heath, GB S.R. TAYLOR: "Digitally controlled attenuator"**
**IEEE JOURNAL OF SOLID-STATE CIRCUITS, Band SC-16, Nr. 1, Februar 1981, Seiten 15-20, IEEE, New York, US M.J. HYNES u.a.: "A CMOS digitally controlled audio attenuator for Hi-Fi systems"**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Höhn, Wolfgang, Dipl.-Ing., Keltenring 35, D-7815 Kirchzarten (DE)**

(74) Vertreter: **Morstadt, Volker, Dipl.-Ing. et al, c/o Deutsche ITT Industries GmbH Patent/Lizenzabteilung Postfach 840 Hans-Bunte-Strasse 19, D-7800 Freiburg/Brsg. (DE)**

EP 0 122 300 B1

**Beschreibung**

Die Erfindung betrifft eine integrierte Schaltung mit einem binären integrierten Digital-Analog-Wandler zur Erzeugung einer mittels eines Digitalsignals einstellbaren Klemmenspannung aus der Spannung einer Spannungsquelle. Diese und die weiteren Merkmale des Oberbegriffs des Anspruchs 1 sind aus der Druckschrift der Firma Valvo GmbH «Technische Informationen für die Industrie», Nr. 791221, Dezember 1979, bekannt. Bei der bekannten Anordnung kann der Wertebereich der analogen Ausgangsspannung, also der Klemmenspannung, zwischen 0 und 5 Volt betragen, wobei der integrierte Digital-Analog-Wandler mit seiner entsprechenden Aussenbeschaltung an einer positiven Spannung von 5 Volt und einer negativen Spannung von −15 Volt betrieben ist. Der obige Klemmenspannungsbereich ist für viele Anwendungsfälle, beispielsweise für den Betrieb von Kapazitätsdioden in Rundfunk- und Fernsehempfängern, zu klein; in welchem Fall er bei etwa 30 Volt liegt.

Die Aufgabe der in den Ansprüchen gekennzeichneten Erfindung besteht somit darin, den bekannten integrierten Digital-Analog-Wandler mit Aussenbeschaltung so weiterzubilden, dass damit ein beliebig grosser Klemmenspannungsbereich erzielt wird, der insbesondere so gross ist, dass die Klemmenspannung zum Betrieb von Kapazitätsdioden von Rundfunk- und Fernsehgeräten dienen kann. Ferner soll unabhängig von der Höhe der Spannung, aus der die Klemmenspannung gewonnen wird, die Stellenzahl des an den Eingang des Digital-Analog-Wandlers angelegten Digitalsignals dem gesamten Klemmenspannungsbereich entsprechen. Wenn also beispielsweise ein neunstelliges binäres Digitalsignal vorliegt, so können damit $2^9$ = 512 Spannungsstufen unterschieden werden; diese sollen unabhängig von der momentanen Höhe der Spannung dieser immer vollständig zugeordnet sein, ob sie nun gerade 30, 31 oder nur 28 Volt beträgt.

Ein Vorteil der Erfindung besteht darin, dass es nicht erforderlich ist, irgendwelche Bauelemente von aussen an die integrierte Schaltung anzuschliessen, abgesehen von der daran beispielsweise zu betreibenden Kapazitätsdiode. Ein weiterer Vorteil besteht darin, dass für den Fall positiver Klemmenspannung und demzufolge positiver Spannung und positiver Betriebsspannung im Digital-Analog-Wandlerteil ausschliesslich npn-Transistoren verwendet werden können. Die integrierte Schaltung nach der Erfindung enthält somit ausser den beiden pnp-Stromquellen und einigen weiteren allfällig erforderlichen pnp-Transistoren ausschliesslich npn-Transistoren und ggf. einen Isolierschicht-Feldeffekttransistor.

Die Erfindung wird nun anhand der Figuren der Zeichnung näher erläutert.

Fig. 1 zeigt ein Prinzipblockschaltbild der integrierten Schaltung der Erfindung,

Fig. 2 zeigt und erläutert das verwendete Schaltsymbol für einen npn-Stromspiegel,

Fig. 3 zeigt und erläutert das verwendete Schaltsymbol für einen pnp-Stromspiegel, und

Fig. 4 zeigt das teilweise schematische Schaltbild eines Ausführungsbeispiels der Erfindung für positive Spannung und Betriebsspannung.

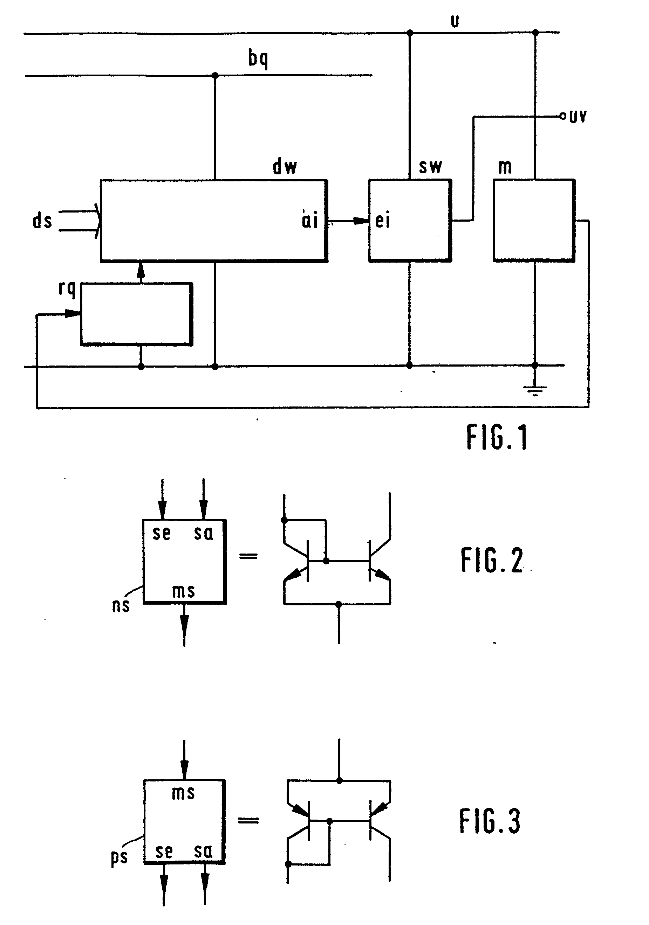

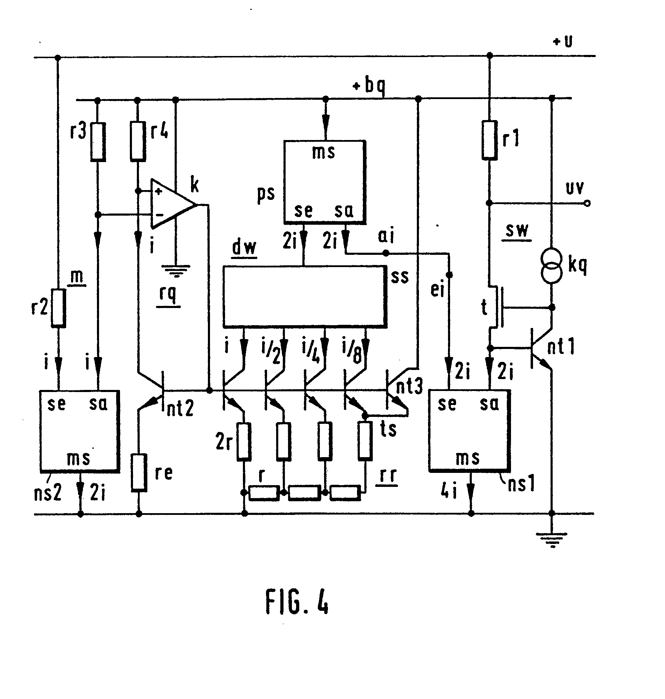

Im schematischen Blockschaltbild der Fig. 1 ist der integrierte Digital-Analog-Wandler dw gezeigt, dessen Digitaleingang das Digitalsignal ds entweder in paralleler oder in serieller Form zugeführt ist. Durch den Pfeil an der bandförmigen Leitung mit dem Bezugszeichen ds soll die eben erwähnte parallele Datenzuführung angedeutet sein. Nach einem ersten Merkmal der Erfindung ist der Digital-Analog-Wandler dw an der einzigen Betriebsspannungsquelle bq betrieben, die beispielsweise nach dem Ausführungsbeispiel der Fig. 4 so geschaltet sein kann, dass der Schaltungsnullpunkt mit deren negativem Pol verbunden ist und somit dort von einer positiven Betriebsspannung +bq zu sprechen ist.

Nach einem weiteren Merkmal der Erfindung ist die Referenzspannungsquelle rq und der Stromspannungswandler sw in die integrierte Schaltung einbezogen, d. h. diese Schaltungsteile sind auf demselben einkristallinen Halbleiterkörper ausgebildet wie der Digital-Analog-Wandler dw.

In Fig. 1 ist gezeigt, dass der Stromausgang ai des Digital-Analog-Wandlers mit dem Stromeingang ei des Stromspannungswandlers sw verbunden ist, der seinerseits an der Spannungsquelle u betrieben ist, aus der die vom Digitalsignal ds abhängige Klemmenspannung uv gebildet wird. Die Spannungsquelle u ist ebenfalls wie die Betriebsspannungsquelle bq eine Gleichspannungsquelle, von der der gleiche Pol am Schaltungsnullpunkt liegt wie bei der Betriebsspannungsquelle bq. In Fig. 4 liegt somit ebenfalls der negative Pol der Spannungsquelle u am Schaltungsnullpunkt, so dass dort von der positiven Spannung +u zu sprechen ist, an der der Stromspannungswandler sw angeschlossen ist.

An der Spannungsquelle u ist ferner der Messkreis m angeschlossen, dessen anderer Anschluss am Schaltungsnullpunkt liegt und dessen Ausgangssignal der Referenzspannungsquelle rq derart zugeführt ist, dass der Maximalwert des Digitalsignals ds immer der Spannung u zugeordnet ist. Im Gegensatz zu üblichen Regelschaltungen, die zur Konstanthaltung eines Ausgangssignals meist mittels des Messkreises eine Rückwärtsregelung vornehmen, handelt es sich also bei der Erfindung sowohl bewusst um keine Konstantregelung als auch bewusst um eine Vorwärtsregelung.

Die Referenzspannungsquelle rq liegt in Fig. 1 einseitig am Schaltungsnullpunkt und steuert, wie aus der eingangs genannten Druckschrift bekannt, den in den Wandlerstufen des Digital-Analog-Wandlers dw fliessenden Strom.

Die Figuren 2 und 3 zeigen zwei in Fig. 4 jeweils verwendete Schaltsymbole für einen npn-Stromspiegel ns (Fig. 2) und einen pnp-Stromspiegel (ps) (Fig. 3) sowie die einfachste Möglichkeit zu dessen Realisierung mittels zwei npn- bzw. pnp-Transistoren. Der einfachste Stromspiegel besteht somit aus zwei Transistoren gleichen Leitungstyps, deren Basis-Emitter-Strecken parallelgeschaltet sind und bei deren einem Kollektor und Basis miteinander verbunden sind. Die Stromspiegeleigenschaft ergibt sich dadurch, dass die Basis-Emitter-pn-Übergangsflächen beider Transistoren gleich sind. In diesem Fall fliesst in den beiden Kollektor-Emitter-Kreisen der Transistoren derselbe Strom, d. h. der im einen Transistor fliessende Strom wird im anderen «gespiegelt». Weichen dagegen die Basis-Emitter-pn-Übergangsflächen in ihrer Grösse voneinander ab, so verhält sich der Strom im einen Transistor zu dem im anderen wie diese Übergangsflächen. In diesem Fall spricht man nicht mehr von Stromspiegeln, sondern von Stromübersetzern. Wenn nun beispielsweise wie weiter unten anhand der Fig. 4 noch im einzelnen geschildert wird, in einem Stromspiegel der doppelte Strom gespiegelt werden soll wie in einem anderen Stromspiegel, so müssen auch die Transistoren dieses den doppelten Strom führenden Stromspiegels die doppelte pn-Übergangsfläche haben wie die des anderen.

Die erläuterte einfachste Realisierung soll jedoch keine Einschränkung darstellen, denn es sind im einschlägigen Stand der Technik bezüglich Stromspiegeln die unterschiedlichsten Schaltungen aus zwei, drei und mehr Transistoren bekannt, die im Bedarfsfall bei der Erfindung ebenfalls verwendet werden können.

Zur Vereinheitlichung der Bezeichnungsweise für die drei Pole eines Stromspiegels ist bei der vorliegenden Erfindung unabhängig von der konventionellen Stromrichtung immer von Stromeingang se, Stromausgang sa und Summenausgang ms die Rede, wobei der Stromeingang immer derjenige Anschluss ist, an dem der Transistor mit Basis-Kollektor-Verbindung angeschlossen ist. Der über den Stromeingang se fliessende Strom erscheint gespiegelt als über den Stromausgang sa fliessender Strom, wobei die Summe dieser beiden Ströme über den Summenausgang ms fliesst.

Die Fig. 4 zeigt teilweise blockschaltbildmässig die Schaltung eines Ausführungsbeispiels der Erfindung für positive Spannung und Betriebsspannung, d. h. die negativen Pole der Spannungsquelle u und der Betriebsspannungsquelle bq nach Fig. 1 liegen am Schaltungsnullpunkt und somit deren positive Pole an den entsprechenden Schaltungsteilen in Fig. 4. Der pnp-Stromspiegel ps ist allen Wandlerstufen des Digital-Analog-Wandlers dw derart zugeordnet, dass der Summenausgang ms an der positiven Betriebsspannung +bq, der Stromausgang sa am Eingang ei des Stromspannungswandlers sw und der Stromeingang se an allen Schaltstufen ss liegt. Dabei ist der Stromausgang sa mit dem Stromausgang ai des Digital-Analog-Wandlers identisch. Der Eingang ei des Stromspannungswandlers sw ist mit dem Stromeingang se des ersten npn-Stromspiegels ns1 identisch, dessen Summenausgang ms am Schaltungsnullpunkt liegt.

Der Stromspannungswandler sw enthält ferner den mit dem einen Anschluss am positiven Pol der Spannungsquelle +u liegenden ersten Widerstand r1, an dessen anderem Anschluss die Klemmenspannung uv auftritt. Von diesem Anschluss führt der gesteuerte Strompfad des bezüglich der Spannung u spannungsfesten Transistors t zum Stromausgang sa des ersten npn-Stromspiegels ns1.

Die Steuerelektrode des Transistors t liegt einerseits über die Konstantstromquelle kq am positiven Pol der Betriebsspannungsquelle +bq und andererseits über die Kollektor-Emitter-Strecke des ersten npn-Transistors nt1 am Schaltungsnullpunkt, dessen Basis wiederum am Stromausgang sa des ersten npn-Stromspiegels ns1 angeschlossen ist. Mittels des ersten npn-Transistors nt1 wird erreicht, dass der Klemmenspannungshub bis auf die Basis-Emitter-Schwellspannung des Transistors nt1 identisch mit der Spannung u ist. Dieser Transistor nt1 zieht nämlich die Steuerelektrode des Transistors t auf die Kollektor-Emitter-Sättigungsspannung des Transistors nt1, die bekanntlich bei etwa 0,1 bis 0,2 Volt liegt, also praktisch identisch mit dem Schaltungsnullpunktpotential ist.

Der Messkreis m besteht im Ausführungsbeispiel nach Fig. 4 aus dem zweiten npn-Stromspiegel ns2 sowie dem zweiten Widerstand r2, dessen einer Anschluss am positiven Pol der Spannung +u liegt und dessen anderer Anschluss mit dem Stromeingang se dieses npn-Stromspiegels ns2 verbunden ist, dessen Summenausgang ms am Schaltungsnullpunkt liegt. Der über den Stromeingang se des Stromspiegels ns2 fliessende Strom, der von der Spannung der Spannungsquelle +u und dem Widerstandswert des zweiten Widerstandes r2 abhängig ist, ist somit ein Mass für diese Spannung.

Die Referenzspannungsquelle rq enthält im Ausführungsbeispiel nach Fig. 4 den zweiten npn-Transistor nt2 und den diesem zugeordneten Emitterwiderstand re, der einseitig am Schaltungsnullpunkt liegt. Die Basis des zweiten npn-Transistors nt2 liegt an den Basen der den Strom in den einzelnen Wandlerstufen bestimmenden Transistoren ts, deren Basis-Emitter-pn-Übergangsflächen von Stufe zu Stufe den doppelten Wert haben. Der Stromausgang sa des zweiten npn-Stromspiegels ns2 liegt über den dritten Widerstand r3 ebenso wie der Kollektor des zweiten npn-Transistors nt2 über den vierten Widerstand r4 am positiven Pol der Betriebsspannungsquelle +bq, wobei deren Widerstandswerte vorzugsweise gleich sind.

In den Emitterkreisen der strombestimmenden Transistoren ts liegt das R-2R-Netzwerk rr, wobei die mit dem jeweiligen Emitter verbundenen Widerstände den Widerstandswert 2r und die diese Widerstände verbindenden Widerstände den Widerstandswert r haben und der ganz links liegende dieser Emitterwiderstände am Schaltungsnullpunkt liegt. Als Abschlusselement des R-2R-Netzwerks rr dient der dritte npn-Transistor nt3, dessen Basis-Emitter-Strecke der desjenigen Transistors parallelgeschaltet ist, in dem der kleinste Strom, in Fig. 4 also i/8, fliesst (das ist der der niederstwertigen Stelle des Digitalsignals ds zugeordnete Strom), und dessen Kollektor am positiven Pol der Betriebsspannungsquelle +bq liegt.

Die Referenzspannungsquelle rq enthält ferner den Operationsverstärker k, dessen invertierender Eingang − am dritten Widerstand r3 und dessen nichtinvertierender Eingang + am vierten Widerstand r4 liegt, nämlich jeweils an deren betriebsspannungsabgewandten Pol. Der Operationsverstärker k ist von der positiven Betriebsspannungsquelle +bq spannungsversorgt. In Fig. 4 ist bezüglich der in den einzelnen Stromspiegeln und den damit verbundenen Schaltungsteilen fliessenden Ströme, ausgehend von dem über den Stromeingang se fliessenden Strom i des zweiten npn-Stromspiegels ns2, gezeigt, wie sich dieser Strom i durch wiederholte Spiegelung beziehungsweise Einregelung mittels des Operationsverstärkers k schliesslich als grösster Strom i des am weitesten links liegenden strombestimmenden Transistors der Transistoren ts wiederfindet, und zwar für den speziellen Fall, dass gilt: re = 2r; r3 = r4, wobei der volle Klemmenspannungshub für r2 = 2r1 auftritt. Entsprechend der oben angegebenen Flächenbemessung der Transistoren ts fliesst in den übrigen Transistoren jeweils die Hälfte des in dem links vorausgehenden Transistor fliessenden Stroms, so dass die Summe dieser Ströme, die mittels der Schaltstufen ss gebildet wird, im Idealfall gleich 2i ist und über den Stromeingang se des pnp-Stromspiegels ps fliesst. Diese Stromsumme 2i wird wiederum durch wiederholte Spiegelung zum Strom 2i im Schaltungszweig mit dem ersten Widerstand r1 und dem Transistor t gemacht. Somit ist ohne weiteres ersichtlich, dass der Strom i im Messkreis m die Klemmenspannung uv proportional beeinflusst, wobei eine gleichlaufende Beeinflussung dann vorliegt, wenn der Widerstandswert des ersten Widerstands r1 halb so gross ist wie der Widerstandswert des zweiten Widerstands r2.

**Patentansprüche**

1. Integrierte Schaltung mit einem binären integrierten Digital-Analog-Wandler (dw) zur Erzeugung einer mittels eines Digitalsignals (ds) einstellbaren Klemmenspannung (uv) aus der Spannung einer Spannungsquelle (u), wobei dem Stromausgang (ai) des Digital-Analog-Wandlers (dw) ein Stromspannungswandler (sw) nachgeschaltet ist, wobei ferner der Digital-Analog-Wandler (dw) aus Wandlerstufen besteht, die den darin jeweils fliessenden Strom bestimmende Transistoren (ts) mit zugehörigem R-2R-Netzwerk (rr) sowie diese Einzelströme schaltende Schaltstufen (ss) enthält und wobei dem integrierten Digital-Analog-Wandler (dw) eine die Stromstärke der in den Wandlerstufen fliessenden Ströme bestimmende Referenzspannungsquelle (rq) zugeordnet ist, gekennzeichnet durch folgende Merkmale:
− Referenzspannungsquelle (rq) und Stromspannungswandler (sw) sind in die integrierte Schaltung einbezogen,

− der Digital-Analog-Wandler (dw) ist an einer einzigen Betriebsspannungsquelle (bq) betrieben,
− die Spannungsquelle (u) und die Betriebsspannungsquelle (bq) sind zwei verschiedene Gleichspannungsquellen mit gemeinsamem Schaltungsnullpunkt am gleichen Pol und
− es ist ein Messkreis (m) für die Spannung der Spannungsquelle (u) vorhanden, dessen Ausgangsgrösse der Referenzspannungsquelle (rq) derart zugeführt ist, dass der Maximalwert des Digitalsignals (ds) immer der Spannung der Spannungsquelle (u) zugeordnet ist.

2. Integrierte Schaltung nach Anspruch 1 für positive Betriebsspannung und positive Spannung, gekennzeichnet durch folgende Merkmale:
− ein pnp-Stromspiegel (ps) ist allen Wandlerstufen derart zugeordnet, dass dessen Summenausgang (ms) am positiven Pol der Betriebsspannungsquelle (+bq), dessen Stromausgang (sa) am Eingang (ei) des Stromspannungswandlers (sw) und dessen Stromeingang (se) an allen Schaltstufen (ss) liegt,
− der Eingang (ei) des Stromspannungswandlers (sw) ist der Stromeingang (se) eines ersten npn-Stromspiegels (ns1), dessen Summenausgang (ms) am Schaltungsnullpunkt liegt,
− der Stromspannungswandler (sw) enthält ferner einen mit dem einen Anschluss am positiven Pol der Spannungsquelle (+u) liegenden ersten Widerstand (r1), an dessen anderem Anschluss die Klemmenspannung (uv) auftritt, von dem der gesteuerte Strompfad eines bezüglich der Spannung der Spannungsquelle (+u) spannungsfesten Transistors (t) zum Stromausgang (sa) des ersten npn-Stromspiegels (ns1) führt, und
− die Steuerelektrode des spannungsfesten Transistors (t) liegt über eine Konstantstromquelle (kq) am positiven Pol der Betriebsspannungsquelle (+bq) und über die Kollektor-Emitter-Strecke eines ersten npn-Transistors (nt1) am Schaltungsnullpunkt, dessen Basis am Stromausgang (sa) des ersten npn-Stromspiegels (ns) angeschlossen ist.

3. Integrierte Schaltung nach den Ansprüchen 1 und 2, dadurch gekennzeichnet, dass der Messkreis (m) aus einem mit dem Summenausgang (ms) am Schaltungsnullpunkt angeschlossenen zweiten npn-Stromspiegel (ns2) sowie einem zweiten Widerstand (r2) besteht, dessen einer Anschluss am positiven Pol der Spannung (+u) und dessen anderer Anschluss am Stromeingang (se) des zweiten npn-Stromspiegels (ns2) liegt, und dass der Widerstandswert des zweiten Widerstands (r2) doppelt so gross ist wie der des ersten Widerstands (r1).

4. Integrierte Schaltung nach Anspruch 3, gekennzeichnet durch folgende Merkmale:
− die Referenzspannungsquelle (rq) enthält einen zweiten npn-Transistor (nt2) und einen diesem zugeordneten Emitterwiderstand (re), der einseitig am Schaltungsnullpunkt liegt, ferner einen dritten Widerstand (r3), der zwischen dem positiven Pol der Betriebsspannung (+bq) und dem Stromausgang (sa) des zweiten npn-Stromspiegels (ns2) liegt, sowie einen vierten Widerstand (r4), der den Kollektor des zweiten npn-Transistors (nt2) mit dem positiven Pol der Betriebsspannung (+bq) verbindet, und schliesslich einen Operationsverstärker (k), bei dem der nicht invertierende Eingang am betriebsspannungsabgewandten Anschluss des vierten Widerstands (r4) sowie der invertierende Eingang am betriebsspannungsabgewandten Anschluss des dritten Widerstands (r3) und dessen Ausgang mit der Basis des zweiten npn-Transistors (nt2) sowie mit den Basen der den Strom in den einzelnen Wandlerstufen bestimmenden Transistoren (ts) verbunden ist, deren Basis-Emitter-pn-Übergangsflächen von Stufe zu Stufe den doppelten Wert haben.

5. Integrierte Schaltung nach einem der Ansprüche 1 bis 4, dadurch gekennzeichnet, dass der spannungsfeste Transistor (t) ein Isolierschicht-Feldeffekttransistor ist.

**Claims**

1. Integrated circuit comprising a binary integrated digital-to-analog converter (dw) for generating from the voltage of a voltage source (u), a terminal voltage (uv) adjustable by a digital signal (ds), with the current output (ai) of the digital-to-analog converter (dw) being followed by an output current-to-voltage converter (sw), with moreover, the digital-to-analog converter (dw) consisting of converting stages containing the transistors (ts) respectively determining the current flowing therein, and the associated R-2R-ladder network (rr), as well as switching stages (ss) for these individual currents, and with the integrated digital-to-analog converter (dw) being associated with a source of reference voltage (rq) which is determinative of the current intensity of the currents flowing in the converting stages, characterized by the following features:
– Both the reference voltage source (rq) and the current-to-voltage converter (sw) are included in the integrated circuit,
– the digital-to-analog converter (dw) is operated from one single source of operating (supply) voltage (bq),
– the voltage source (u) and the operating (supply) voltage source (bq) are two different sources of dc voltage having a common zero point of circuit at the same pole, and
– there is provided a measuring circuit (m) for the voltage of the voltage source (u), whose output quantity is in such a way fed to the source of reference voltage (rq), that the maximum value of the digital signal (ds) is always associated with the voltage of the voltage source (u).

2. An integrated circuit for a positive operating (supply) voltage and a positive voltage, characterized by the following features:
– a first pnp current mirror (ps1) is associated in such a way with all converting stages that the summation output (ms) thereof is connected to the positive pole of the source of operating (supply) voltage (+bq), that the current output (sa) thereof is connected to the input (ei) of the current-to-voltage converter (sw) and that the current input (se) thereof is connected to all switching stages (ss),
– the input (ei) of the current-to-voltage converter (sw) is the current input (se) of a first npn current mirror (ns1) whose summation output (ms) is connected to the zero point of the circuit,
– the current-to-voltage converter (sw) moreover contains a first resistor (r1) which, with its one terminal, is connected to the positive pole of the source of voltage (+u), with the terminal voltage (uv) appearing at the other terminal thereof, from which the controlled current path of a transistor (t) which is voltage-stabilized with respect to the voltage of the source of voltage (+u), extends to the current output (sa) of the first npn current mirror (ns1), and
– the control electrode of the voltage-stabilized transistor (t) is connected via a source of constant current (kq), to the positive pole of the source of operating (supply) voltage (+bq) and, via the collector-emitter path of a first npn transistor (nt1), to the zero point of the circuit, with the base electrode thereof being connected to the current output (sa) of the first npn current mirror (ns).

3. An integrated circuit as claimed in claims 1 and 2, characterized in that said measuring circuit (m) consists of a second npn current mirror (ns2) connected with the summation output (ms) to the zero point of the circuit, as well as of a second resistor (r2) whose one terminal is connected to the positive pole of the voltage (+u) and whose other terminal is connected to the current input (se) of the second npn current mirror (ns2), and that said second resistor (r2) has a resistance value which is double as high as that of said first resistor (r1).

4. An integrated circuit as claimed in claim 3, characterized by the following features:
– the source of reference voltage (rq) contains a second npn transistor (nt2) and an emitter resistor (re) associated therewith, which is connected with one side to the zero point of the circuit, and moreover a third resistor (r3) lying between the positive pole of the operating (supply) voltage (+bq) and the current output (sa) of said second npn current mirror (ns2), as well as a fourth resistor (r4) connecting the collector of said second npn transistor (nt2) to the positive pole of the operating (supply) voltage (+bq), and finally contains an operational amplifier (k) whose non-inverting input is connected to the terminal of said fourth resistor (r4) not facing the operating (supply) voltage and whose inverting input is connected to the terminal of said third resistor (r3) not facing the operating (supply) voltage, and whose output is connected to the base of said second npn transistor (nt2) as well as to the base electrodes of the transistors (ts) determining the current flowing in the individual converting stages, with the base-emitter pn junction areas having values doubling from stage to stage.

5. An integrated circuit as claimed in any one of claims 1 to 4, characterized in that said voltage-stabilized transistor (t) is an insulated-gate field-effect transistor.

## Revendications

1. Circuit intégré comprenant un convertisseur numérique-analogique binaire intégré (dw) pour engendrer, à partir de la tension de source d'une source de tension (u), une tension de sortie (uv) ajustable au moyen d'un signal numérique (ds), la sortie de courant (aï) du convertisseur numérique-analogique (dw) étant suivie par un convertisseur courant-tension (sw) et, de plus, le convertisseur numérique-analogique comportant des étages de conversion contenant des transistors (ts) déterminant chacun le courant qui le traverse, en relation avec le réseau en échelle R-2R associé (rr), de même que des étages de commutation (ss) pour ces courants individuels, tandis que ce convertisseur numérique-analogique (dw) est associé à une source de tension de référence (rq) qui détermine l'intensité des courants traversant les étages de conversion, caractérisé en ce que:

– la source de tension de référence (rq) et le convertisseur courant-tension (sw) sont tous les deux inclus dans le circuit intégré,

– le convertisseur numérique-analogique (dw) est alimenté par une seule source de tension d'alimentation (bq),

– la source de tension (u) et la source de tension d'alimentation (bq) sont deux sources de tension continue différentes ayant un circuit de masse commun correspondant au même pôle et

– il est prévu un circuit de mesure (m) de la tension de la source de tension (u) dont la valeur de sortie est fournie à la source de tension de référence (rq) de façon telle que la valeur maximale du signal numérique (ds) est toujours associée à la tension de la source de tension (u).

2. Circuit intégré selon la revendication 1 pour tension d'alimentation positive et tension de source positive, caractérisé en ce que:

– un miroir de courant PNP (ps) est associé à tous les étages de conversion de façon que sa sortie de sommation (ms) soit connectée au pôle positif de la source de tension d'alimentation (+bq), que sa sortie de courant (sa) soit connectée à l'entrée (ei) du convertisseur courant-tension (sw) et que son entrée de courant (se) soit connectée à tous les étages de commutation (ss),

– l'entrée (ei) du convertisseur courant-tension (sw) est l'entrée de courant (se) d'un premier miroir de courant NPN (ns1) dont la sortie de sommation (ms) est connecté à la masse du circuit,

– le convertisseur courant-tension (sw) contient de plus une première résistance (r1) qui, par l'une de ses bornes, est connectée au pôle positif de la source de tension (+u), la tension de sortie (uv) apparaissant sur son autre borne, à partir de laquelle le trajet de courant commande d'un transistor (t) stabilisé en tension par rapport à la tension de la source de tension (+u) s'étend jusqu'à la sortie de courant (sa) du premier miroir de courant NPN (ns1), et

– l'électrode de commande du transistor stabilisé en tension (t) est connectée, par l'intermédiaire d'une source de courant constant (kq), au pôle positif de la source de tension d'alimentation (+bq) et, par l'intermédiaire du trajet émetteur-collecteur d'un premier transistor NPN (nt1), à la masse du circuit, son électrode de base étant connectée à la sortie de courant (sa) du premier miroir de courant NPN (ns).

3. Circuit intégré selon les revendications 1 et 2, caractérisé en ce que le circuit de mesure (m) consiste en un second miroir de courant NPN (ns2) dont le point de sommation (ms) est connectée à la masse du circuit, ainsi qu'une deuxième résistance (r2) dont une borne est connectée au pôle positif de la tension de source (+u) et dont l'autre borne est connectée à l'entrée de courant (se) du deuxième miroir de courant NPN (ns2), et en ce que la deuxième résistance (r2) a une valeur de résistance qui est double de celle de la première résistance (r1).

4. Circuit intégré selon la revendication 3, caractérisé en ce que la source de tension de référence (rq) contient un deuxième transistor NPN (nt2) et une résistance d'émetteur (re) qui lui est associée, connectée d'un côté à la masse du circuit et, en outre, une troisième résistance (r3) disposée entre le pôle positif de la source de tension d'alimentation (+bq) et la sortie de courant (sa) du second miroir de courant NPN (ns2), ainsi qu'une quatrième résistance (r4) connectant le collecteur du deuxième transistor NPN (nt2) au pôle positif de la source de tension d'alimentation (+bq) et, finalement, contient un amplificateur opérationnel (k) dont l'entrée non-inverseuse est connectée à la borne de la quatrième résistance (r4) non tournée vers la tension d'alimentation, dont l'entrée inverseuse est connectée à la borne de la troisième résistance (r3) non tournée vers la tension d'alimentation et dont la sortie est connectée à la base du deuxième transistor NPN (nt2) de même qu'aux électrodes de base des transistors (ts) déterminant le courant parcourant les étages de conversion individuels, dont les surfaces des jonctions PN base-émetteur sont doublées d'un étage au suivant.

5. Circuit intégré selon l'une quelconque des revendications 1 à 4, caractérisé en ce que le transistor stabilisé en tension (t) est un transistor à effet de champ à grille isolée.

FIG.1

FIG.2

FIG.3

0122300

FIG. 4

9